# EUROPEAN PATENT APPLICATION

(11) **EP 2 511 349 A2**
(43) Date of publication of application: **17.10.2012**
(21) Application number: 10836165.0
(22) Date of filing: 01.12.2010
(51) Int. Cl.: C09D 1/00, C03C 17/06, H01L 31/042

(54) **METHOD FOR PREPARING A COATING SOLUTION FOR INCREASING THE LIGHT TRANSMITTANCE OF SOLAR CELL MODULE GLASS, AND COATING SOLUTION COMPOSITION PREPARED BY THE METHOD**

(30) Priority: 07.12.2009 KR 20090120735
(71) Applicant: Hytc Co. Ltd., Seoul 152-887 (KR)
(72) Inventor: KIM, Yook-Jung, Gwangmyeong-si Gyeonggi-do 423-060 (KR); JANG, Jin-Ho, Daejeon Metropolitan City 305-509 (KR)
(74) Representative: Novagraaf Technologies
(86) International application number: PCT/KR2010/008557
(87) International publication number: WO 2011/071269

(57) **Abstract**

Provided are an method for producing a coating solution with which glass used for the production of solar collector modules is coated to enhance the optical transmittance, and a coating composition produced by the same. According to the prior art, there is a method of alternately stacking a high refractive index layer and a low refractive index layer on each other, coating a film with a photocatalyst for the anti-reflection of films, or using alkoxysilane having a porous structure, in order to increase the transmission of light. However, the prior-art method has problems in that it is difficult to precisely stack the high and low refractive index layers, the production cost is high, and the storage stability of the coating solution is restricted, which makes it difficult to use the prior-art method. However, the present invention is designed to solve such drawbacks of the prior art, the production method and coating composition may be useful to arrange the inorganic particles with a diameter of several ten nanometers to several hundred nanometers so that the inorganic nanoparticles can have a similar array to the porous structure, thereby improving the mechanical property (for example, hardness) of the filler while enhancing the transmittance of the porous structure.

## Description

### CROSS-REFERENCE TO RELATED APPLICATIONS

This application claims the priority of Korean Patent Application No.10-2009-0120735 filed on December 7, 2009, in the Korean Intellectual Property Office, the disclosure of which is incorporated herein by reference.

### BACKGROUND OF THE INVENTION

### Field of the Invention

The present invention relates to the production of a coating solution with which glass used for the production of solar collector modules is coated to enhance the optical transmittance.

### Description of the Related Art

The present invention relates to the production of a coating solution with which glass used for the production of solar collector modules is coated to enhance the optical transmittance.

When the light is incident vertically to glass, some of the incident light is lost through the reflection on the air/glass interface. In this case, the reflection loss of the incident light accounts to approximately 4%. For the glass used to cover a photovoltaic system, for example a photoelectric cell or a solar collector, the reflection loss results in a decrease in the efficiency of the photovoltaic system. Therefore, there are a variety of methods to produce a coating layer on the surface of glass for the purpose of enhancing the light transmission through the glass.

When at least two layers of a high refractive index material and a low refractive index material are alternately stacked on each other, the wavelength of the reflected light disappears at a certain wavelength range. One example of such layers includes an anti-reflective layer formed on an architectural glass from Schott Glaswerke. Here, the anti-reflective layer is produced by the sol-gel method, and is subject to dip coating. However, the frequency bandwidth of such anti-reflective coatings is physically restricted to one octave, and the use of the anti-reflective coatings is suitable only at a visible ray range, but not suitable at a solar spectrum range having a wide bandwidth.

Korean Patent Publication No. 10-2008-0023888 discloses an anti-reflective glass for an automobile. Here, the anti-reflective glass is designed to shows its low reflection property by allowing a coating layer made of at least two materials of different refractive indexes to absorb or optically interfere with the light in the visible ray range, thereby reducing the amount of reflected light. More particularly, there has been an attempt to develop a multilayer coating process in which a number of layers are stacked by using a deposition method. However, the multilayer coating process has problems in that there is a limitation on the size of glass to be deposited, a film is difficult to be mass-produced on each layer when the thickness of the film is controlled with high precision, and its economical efficiency is low.

In order to sole these problems, there is a wet coating method proposed. For example, Korean Registered Patent No. 10-0653585 discloses an anti-reflective film, a process for forming an anti-reflective film, and an anti-reflective glass. Here, the anti-reflective film containing fluorine atoms is produced by preparing a polysiloxane solution including fluoroalkylsilane and coating a film with the polysiloxane solution by using the conventional coating method. However, the wet coating method has demerits in that fluoroalkylsilane is much more expensive than alkoxysilane, and it is difficult to meet the price of the solar collector modules being on the market.

Furthermore, Korean Registered Patent No. 10-0870213 discloses a photocatalytic composition for anti-reflection and a glass substrate coated with the composition. Here, the patent proposes the photocatalysts for anti-reflection and the production of an anti-reflective coating film using the photocatalysts, but the coating film has an insufficient anti-reflective performance to improve the solar cell efficiencies due to the intrinsic refractive index of titanium (Ti) used as the photocatalyst in the coating film.

Also, Korean Patent Publication No. 10-2004-0035832 discloses a novel hybrid sol for the production of abrasion-resistant SIO₂ anti-reflection layers. Here, alkoxysilane is produced with a porous structure in order to realize the production of an anti-reflective film. However, the alkoxysilane has a problem in that it has the effect of restricting the storage stability of the coating solution under the basic condition, which renders it difficult to produce an anti-reflection coating film in a stable manner.

### SUMMARY OF THE INVENTION

Accordingly, the present invention is designed to solve such drawbacks of the prior art, and therefore an object of the present invention is to provide an optical coating composition capable of enhancing the transmittance through the filling array of inorganic nanoparticles, maintaining constant hardness even at its optical thin film thickness, and minimizing the production cost using a single-layer wet coating method.

According to an aspect of the present invention, there is provided a method for producing a coating solution which is used in glass for use in solar collector modules to enhance the optical transmittance. Here, the method may include: preparing a sol of particles having a diameter of several ten nanometers to several hundred nanometers by adding a coagulation-inducing agent to a coating solution to induce the coagulation of the coating solution by the sol-gel reaction, the coagulation-inducing agent being used to give rise to the sol-gel reaction with radically reactive aluminum alkoxide.

In this case, the coagulation-inducing agent may be at least one substance selected from the group consisting of a silica sol and an alumina sol.

After the sol preparation step, the method according to the present invention may further include: adding a stabilizing agent to the sol prepared in the sol preparation step in order to stabilize the particles.

The method according to the present invention may further include: subjecting the sol prepared in the sol stabilization step to a sol-gel reaction with metal alkoxide after the sol stabilization step.

When both of the silica sol and alumina sol are used as the coagulation-inducing agent, the method according to the present invention may further include: mixing 100 parts by weight of the silica sol with 10 to 40 parts by weight of the alumina sol.

In general, the coagulation-inducing agent is used to convert a basic sol into an acidic sol. When the coagulation-inducing agent is basic, the method according to the present invention may further include: adding an acidic catalyst to change the pH into an acidic range. In this case, the sol-gel reaction may be performed at a temperature of 50°C to 80°C.

The silica sol whose particle size is in a range of 10nm to 200nm may be used to perform the sol-gel reaction.

The alumina sol whose particle size is in a range of 10nm to 200nm may be used to perform the sol-gel reaction.

The coagulated particles may have a diameter of 100nm to 500nm.

According to another aspect of the present invention, there is provided an anti-reflective coating composition including the sol prepared as described above, a silane compound (Si(OR)₄) as the metal alkoxide, water, an organic solvent and a catalyst.

### BRIEF DESCRIPTION OF THE DRAWINGS

The above and other aspects, features and other advantages of the present invention will be more clearly understood from the following detailed description taken in conjunction with the accompanying drawings, in which:
FIGS. 1 and 2 are graphic diagrams showing the optical transmittance after the application of a coating solution according to one exemplary embodiment of the present invention;
FIG. 3 is a magnified plane photograph, in the magnified view, showing a coating layer coated with a coating solution according to one exemplary embodiment of the present invention; and
FIG. 4 is a side photograph showing a coating layer coated with a coating solution according to one exemplary embodiment of the present invention.

### DETAILED DESCRIPTION OF THE PREFERRED EMBODIMENT

Hereinafter, exemplary embodiments of the present invention will now be described in detail with reference to the accompanying drawings.

An object of the present invention is to provide an anti-reflective film having suitable hardness and reliability to be used for solar collectors to produce an anti-reflective film with single layers according to the wet coating method.

As previously stated, the anti-reflective functionality is proposed to realize the porous structure after the metal alkoxysilane is subjected to sol-gel reaction under the basic condition. However, the problem concerning the hardness of a coating film is pointed out as the limitation on the porous structure, and the enhancement of the transmittance ma be offset by an increase in the density of the coating film when metal alkoxysilane is subjected to sol-gel reaction under the acidic condition in order to improve the hardness of the coating film.

Another object of the present invention is to arrange the inorganic particles with a diameter of several ten nanometers to several hundred nanometers so that the inorganic particles can have a similar array to the porous structure, thereby improving the mechanical property (for example, hardness) of the filler while enhancing the transmittance of the porous structure.

When light is passed through pores with a diameter of micrometers formed in the porous structure, the scattered reflection serves to improve the anti-reflective effect, but the light transmittance is too suddenly deteriorated to be suitable for the application to the solar collectors. However, when the size of the inorganic particles decreases from a micrometer scale to a nanometer scale, the light transmittance is improved, and the hardness of the coating film is strengthened according to the kinds of the inorganic particles.

For this purpose, the method according to one exemplary embodiment includes; preparing a sol of particles having a diameter of several ten nanometers to several hundred nanometers by inducing the coagulation of a coating solution by means of the reaction between radically reactive aluminum alkoxide and a coagulation-inducing agent whose pH is acidic, wherein when the coagulation-inducing agent is used to give rise to the sol-gel reaction with radically reactive aluminum alkoxide, the coagulation-inducing agent is used to form a sol whose pH is acidic, whereas an acidic catalyst is added to change the pH into an acidic range when the pH of the coagulation-inducing agent is basic, and the sol-gel reaction is performed at a temperature of 50°C to 80°C.

In this case, an aqueous silica sol may be used as the coagulation-inducing agent, and it is desirable to use the silica sol having a particle size of approximately 10nm to 200nm.

Also, an aqueous alumina sol may be used as the coagulation-inducing agent, and it is desirable to use the alumina sol having a particle size of approximately 10nm to 500nm. The particle size of the alumina sol is preferably in a range of approximately 10nm to 200nm. Also, the aqueous silica sol and the aqueous alumina sol may be used together as the coagulation-inducing agent.

Furthermore, the method according to one exemplary embodiment includes; adding a stabilizing agent to the sol prepared in the sol preparation step in order to stabilize the particles; and subjecting the sol prepared in the sol stabilization step to a sol-gel reaction with metal alkoxide. In this case, the metal alkoxide which may be used herein has the following formula, provided that R represents an alkyl group having up to 10 carbon atoms.

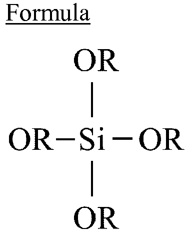

The exemplary embodiment of the present invention will be described in more detail, as follows.

**Example 1**

12.8g of methanol, 7.9g of methyl cellosolve and 0.015g of acetic acid were mixed together in a jacket reactor while the temperature of the jacket reactor was maintained to a temperature of 25°C, and then stirred for 10 minutes to prepare a mixture. Then, 0.05g of brij-56 (poly(oxyethylene) nonionic surfactant) and 0.03mol of polyvinylpyrrolidone (MW: 40,000) were additionally added to the mixture to prepare a surfactant-containing mixture. 2.8g of aluminum tri-sec-butoxide was added to the mixture and mixed at a high speed, and 36g of isopropyl alcohol was mixed with the resultant mixture to prepare an aluminum alkoxide mixture.

HS-40 (Ludox colloidal silica from Grace) was run through a cation exchange resin to convert the HS-40 into an acidic silica sol whose pH value is in a range of approximately 2 to 3, and added dropwise to the previously prepared aluminum alkoxide mixture at a dose of 3 to 10% by weight, based on the total amount of the aluminum alkoxide mixture. Then, the polymerization was performed for 1 to 10 hours using the sol-gel reaction.

After the completion of the sol-gel reaction, 0.1 to 0.5mol of a curing agent (dibutyl tin laurate, DBTDL) and a leveling agent BYK300 were added to prepare a coating composition.

**Example 2**

This example was carried out in the same manner as in Example 1, except that A [Al(OC3H7)3] was used instead of the aluminum tri-sec-butoxide used in Example 1.

**Example 3**

As described in Example 1, an acidic colloidal silica was added to a jacket reactor, and the resultant mixture was warmed and reacted for 1 to 10 hours while maintaining the temperature of the jacket reactor temperature to a temperature of 50 to 70°C, and then cooled to 30°C to perform the sol-gel reaction for 1 to 3 hours.

**Example 4**

As described in Example 1, HS-40, AS and TM as the Ludox colloidal silicas and a silica sol SS-SOL 100 from S. Chemte were mixed at a weight rate of 10%, 20%, 20% and 50%, respectively, and the resultant mixture was run through a cation exchange resin to produce an acidic silica sol whose pH value is in a range of 2 to 3.

A coating composition was prepared in the same manner as in Example 1 using the prepared acidic colloidal silica.

**Example 5**

As described in Example 4, an acidic colloidal silica was added to a jacket reactor, and the resultant mixture was warmed and reacted for 1 to 10 hours while maintaining the temperature of the jacket reactor temperature to a temperature of 50 to 70°C, and then cooled to 30°C to perform the sol-gel reaction for 1 to 3 hours.

**Example 6**

A coating composition was prepared in the same manner as in Example 1, except that NANOBYK-3600(BYK) was used as the alumina sol instead of the acidic colloidal silica used in Example 1.

**Example 7**

As described in Example 6, an alumina sol was added to a jacket reactor, and the resultant mixture was warmed and reacted for 1 to 10 hours while maintaining the temperature of the jacket reactor temperature to a temperature of 50 to 70°C, and then cooled to 30°C to perform the sol-gel reaction for 1 to 3 hours.

**Example 8**

HS-40 and AS as the Ludox colloidal silicas and a silica sol SS-SOL 100 from S. Chemte were mixed at a weight rate of 30%, 20% and 50%, respectively, and the resultant mixture was run through a cation exchange resin to produce an acidic silica sol whose pH value is in a range of 2 to 3.

A coating composition was prepared in the same manner as in Example 1 using the prepared acidic colloidal silica.

Then, an alumina sol NANOBYK-3600 was added dropwise at a weight rate of 10 to 40% to the acidic silica, based on 100parts by weight of the acidic colloidal silica sol to prepare an acidic hybrid nano sol.

A coating composition was prepared in the same manner as in Example 6 using the prepared acidic hybrid nano sol.

**Example 9**

As described in Example 8, the hybrid nano sol was added to a jacket reactor, and the resultant mixture was warmed and reacted for 1 to 10 hours while maintaining the temperature of the jacket reactor temperature to a temperature of 50 to 70°C, and then cooled to 30°C to perform the sol-gel reaction for 1 to 3 hours.

**Example 10**

As described in Example 1, an acidic silica sol was added and kept for 30 minutes, and tetramethoxy silane (TMOS from Aldrich), tetraethoxy silane (TEOS from Aldrich), distilled water and itaconic acid (Aldrich) were added at an amount of 1.3g, 0.8g, 1.5g and 0.03g, respectively, to perform the sol-gel reaction.

**Example 11**

As described in Example 3, the acidic colloidal silica was added to a jacket reactor, and the resultant mixture was warmed and reacted for 1 to 10 hours while maintaining the temperature of the jacket reactor temperature to a temperature of 50 to 70°C, and then cooled to 30°C, and tetramethoxy silane (TMOS from Aldrich), tetraethoxy silane (TEOS from Aldrich), distilled water and itaconic acid (Aldrich) were added at an amount of 1.3g, 0.8g, 1.5g and 0.03g, respectively, to perform the sol-gel reaction for 1 to 5 hours.

**Example 12**

As described in Example 5, the acidic colloidal silica was added to a jacket reactor, and the resultant mixture was warmed and reacted for 1 to 10 hours while maintaining the temperature of the jacket reactor temperature to a temperature of 50 to 70°C, and then cooled to 30°C, and tetramethoxy silane (TMOS from Aldrich), tetraethoxy silane (TEOS from Aldrich), distilled water and itaconic acid (Aldrich) were added at an amount of 1.3g, 0.8g, 1.5g and 0.03g, respectively, to perform the sol-gel reaction for 1 to 5 hours.

**Example 13**

As described in Example 7, the alumina sol was added to a jacket reactor, and the resultant mixture was warmed and reacted for 1 to 10 hours while maintaining the temperature of the jacket reactor temperature to a temperature of 50 to 70°C, and then cooled to 30°C, and tetramethoxy silane (TMOS from Aldrich), tetraethoxy silane (TEOS from Aldrich), distilled water and itaconic acid (Aldrich) were added at an amount of 1.3g, 0.8g, 1.5g and 0.03g, respectively, to perform the sol-gel reaction for 1 to 5 hours.

**Example 14**

As described in Example 9, the hybrid nano sol was added to a jacket reactor, and the resultant mixture was warmed and reacted for 1 to 10 hours while maintaining the temperature of the jacket reactor temperature to a temperature of 50 to 70°C, and then cooled to 30°C, and tetramethoxy silane (TMOS from Aldrich), tetraethoxy silane (TEOS from Aldrich), distilled water and itaconic acid (Aldrich) were added at an amount of 1.3g, 0.8g, 1.5g and 0.03g, respectively, to perform the sol-gel reaction for 1 to 5 hours.

**Comparative example 1**

The sol-gel reaction was performed in the same manner as in Example 11, except that GPTMS [(3-glycidoxypropyl)trimethoxysilane] was used instead of the tetraethoxy silane (TEOS) used in Example 11. The GPTMS gives excellent properties such as hardness and adhesion to the coating films, but has a structure in which alkoxysilane has three OR residues and one R residue. Here, the R residue functions to hinder the formation of a porous structure since its functional group has an epoxy structure, which renders it impossible to enhance the transmittance. As listed in Table 1, it was revealed that the coating composition of Comparative example 1 has poor transmittance. That is, it was seen that different results are given according to the kinds of silanes used in the process of forming a porous structure, in comparison to the present invention.

Each of the coating compositions prepared in Examples 1 to 14 was coated at a coating film thickness of 500nm or less onto Silide Glass (1T) to obtain an optical thin film layer.

The visible light transmittance was measured at a wavelength range of 380 to 800nm using JASCO Model V-570, and the hardness was measured using KS M ISO 15184 : 2002.

The transmittance of the Silide Glass was 90.2%, and the coating compositions prepared in the examples was coated at the coating film thickness, and cured at 200°C. The results are listed in the following Table 1.

**Table 1**

| | Transmittance (Single Surface) | Hardness | Adhesion |
|---|---|---|---|
| Example 1 | 91.1 | H | PASS |
| Example 2 | 90.9 | - | PASS |
| Example 3 | 92.3 | - | PASS |
| Example 4 | 91.6 | H | PASS |
| Example 5 | 92.6 | - | PASS |
| Example 6 | 91.3 | H | PASS |
| Example 7 | 92.4 | - | PASS |
| Example 8 | 91.1 | H | PASS |
| Example 9 | 92.6 | - | PASS |
| Example 10 | 90.8 | H | PASS |
| Example 11 | 92.1 | H | PASS |
| Example 12 | 92.4 | H | PASS |
| Example 13 | 92.2 | 2H | PASS |
| Example 14 | 92.5 | 2H | PASS |
| Comp. example 1 | 90.4 | 2H | PASS |

When each of the coating compositions prepared in Examples 1 to 14 was used to obtain a coating film with the coating film thickness, the coating films showed their improved optical transmittance due to the filling array of the nanoparticles. Also, when the single surface of the Silide Glass was coated with each of the coating compositions, the coating films have an optical transmittance of 1.0 to 2.5%, whereas the coating films have an optical transmittance of 2 to 5% when both surface of the Silide Glass were coated with each of the coating compositions.

Also, the hardness of the coating films was measured to be a H grade or greater due to the filling effect of the inorganic particulates and the presence of the inorganic silane coating film, which makes it possible to solve the problem concerning the deterioration of the hardness caused by the porous structure.

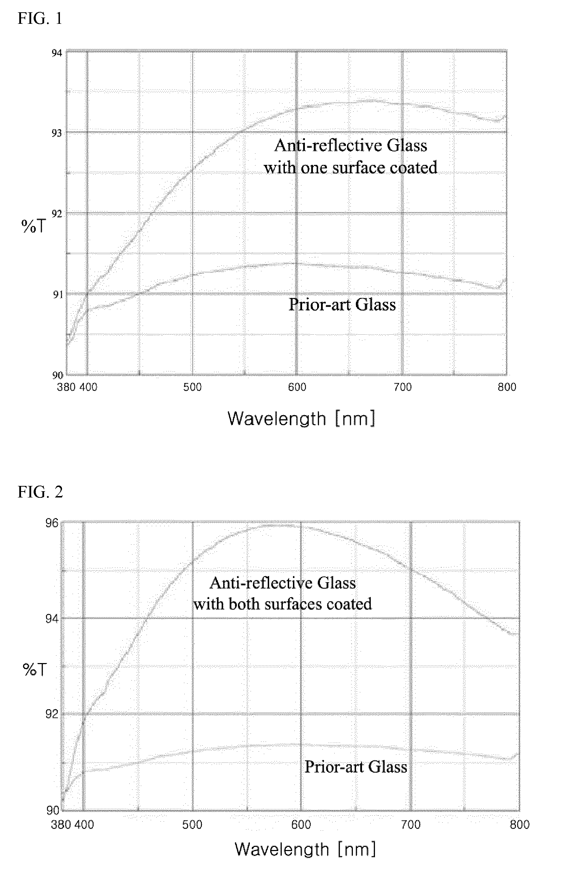

FIG. 1 is a graphic diagram showing the results obtained by comparing the transmittance of the anti-reflective coating glass of Example 14 with that of the prior-ort glass. In this case, the anti-reflective coating glass has one surface coated with the anti-reflective coating composition. Therefore, it was revealed that the difference of the transmittance between the anti-reflective coating glass of Example 14 and the prior-ort glass was measured to be about 2%.

FIG. 2 is a graphic diagram showing the results obtained by comparing the transmittance of the anti-reflective coating glass of Example 14 with that of the prior-ort glass. In this case, the anti-reflective coating glass has both surfaces coated with the anti-reflective coating composition. Therefore, it was revealed that the difference of the transmittance between the anti-reflective coating glass of Example 14 and the prior-ort glass was measured to be about 3% to 5%, depending on the wavelength applied.

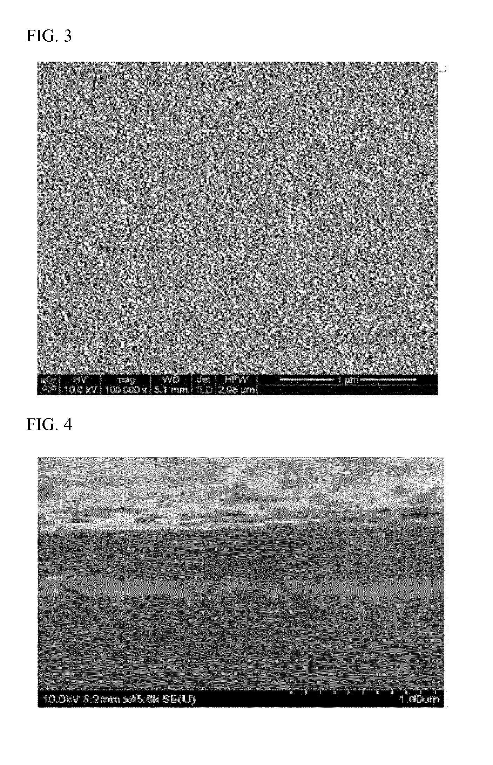

FIG. 3 is a photograph taken of the surface of the anti-reflective coating glass prepared in Example 14 by using FE-SEM, and FIG. 4 is a photograph taken of the side surface of the anti-reflective coating glass by using FE-SEM. As shown in FIGS. 3 and 4, it was revealed that a single layer rather than multiple layers was formed on the anti-reflective coating glass. FIG. 3 shows that the anti-reflective coating glass has a porous top surface, as measured with the FE-SEM, and FIG. 4 shows that the anti-reflective coating glass has a rough side surface due to the presence of the porous structure, as measured with the FE-SEM.

When the anti-reflective coating applies to the outermost glass of the solar collector module, the solar collector module has an improved effect on transmission, but it is difficult to apply the anti-reflective coating to the solar collector module since it has the problems concerning the production costs and reliability due to the design of conventional multi-layer thin film. As described above, the present invention provides the optical coating composition capable of enhancing the transmittance through the filling array of inorganic nanoparticles, maintaining constant hardness even at its optical thin film thickness, and minimizing the production cost using a single-layer wet coating method.

While the present invention has been shown and described in connection with the exemplary embodiments, it will be apparent to those skilled in the art that modifications and variations can be made without departing from the scope of the invention as defined by the appended claims.

## Claims

1. A method for producing a coating solution which is used in glass for use in solar collector modules to enhance the optical transmittance, the method comprising:
preparing a sol of particles having a diameter of several ten nanometers to several hundred nanometers by adding a coagulation-inducing agent to a coating solution to induce the coagulation of the coating solution by the sol-gel reaction, the coagulation-inducing agent being used to give rise to the sol-gel reaction with radically reactive aluminum alkoxide.

2. The method according to claim 1, wherein the coagulation-inducing agent is at least one substance selected from the group consisting of a silica sol and an alumina sol.

3. The method according to claim 2, further comprising:
adding a stabilizing agent to the sol prepared in the sol preparation step in order to stabilize the particles after the sol preparation step.

4. The method according to claim 3, further comprising:
subjecting the sol prepared in the sol stabilization step to a sol-gel reaction with metal alkoxide after the sol stabilization step.

5. The method according to claim 4, further comprising:
mixing 100 parts by weight of the silica sol with 10 to 40 parts by weight of the alumina sol when both of the silica sol and alumina sol are used as the coagulation-inducing agent.

6. The method according to claim 5, further comprising:
adding an acidic catalyst to change the pH into an acidic range when the coagulation-inducing agent is basic although the coagulation-inducing agent is used to convert a basic sol into an acidic sol,
wherein the sol-gel reaction is performed at a temperature of 50°C to 80°C.

7. The method according to claim 6, wherein the silica sol whose particle size is in a range of 10nm to 200nm is used to perform the sol-gel reaction.

8. The method according to claim 6, wherein the alumina sol whose particle size is in a range of 10nm to 200nm is used to perform the sol-gel reaction.

9. The method according to any one of claims 1 to 8, wherein the coagulated particles have a diameter of 100nm to 500nm.

10. An anti-reflective coating composition comprising the sol prepared in any one of claims 1 to 9, a silane compound (Si(OR)₄) as the metal alkoxide, water, an organic solvent and a catalyst.
